# EUROPÄISCHE PATENTANMELDUNG

(11) **EP 3 789 659 A2**
(43) Veröffentlichungstag der Anmeldung: **10.03.2021**
(21) Anmeldenummer: 20190004.0
(22) Anmeldetag: 07.08.2020
(51) Int. Cl.: F21S 41/176, F21S 41/19, F21S 43/16, F21S 43/19, F21S 45/47

(54) **GRUNDKÖRPER FÜR EINE LICHKONVERSIONS- ODER BELEUCHTUNGSEINRICHTUNG**

(30) Priorität: 09.08.2019 DE 102019121508
(71) Anmelder: SCHOTT AG, 55122 Mainz (DE)
(72) Erfinder: GINDELE, Dr. Frank, 85301 Schweitenkirchen (DE); PAWLOWSKI, Edgar, 55271 Stadecken-Elsheim (DE); RAKOBRANDT, Christian, 84419 Schwindegg (DE); STANGL, Christoph, 84172 Buch am Erlbach (DE)
(74) Vertreter: Blumbach · Zinngrebe Patentanwälte PartG mbB

(57) **Zusammenfassung**

Die Erfindung betrifft einen Grundkörper für eine Lichtkonversionseinrichtung und/oder eine Beleuchtungseinrichtung, wobei der Grundkörper insbesondere als Kühlkörper ausgebildet ist, wobei der Grundkörper eine Vorderseite aufweist, welche dazu ausgebildet ist ein Lichtkonversionselement auf dem Grundkörper aufzubringen, wobei der Grundkörper einen Indikator zur Positionierung/Orientierung eines Lichtkonversionselements auf dem Grundkörper aufweist, und/oder einen Indikator zur Positionierung/Orientierung des Grundkörpers gegenüber einem Bauteil zum Halten des Grundkörpers aufweist. Ferner betrifft die Erfindung eine Lichtkonversionseinrichtung sowie eine Beleuchtungseinrichtung umfassend einen solchen Grundkörper, ein Verfahren zur Bearbeitung eines Grundkörpers, sowie Verfahren zur Herstellung einer entsprechenden Lichtkonversionseinrichtung bzw. Beleuchtungseinrichtung.

## Beschreibung

Die Erfindung betrifft einen, insbesondere als Kühlkörper ausgebildeten, Grundkörper für eine Lichtkonversionseinrichtung und/oder eine Beleuchtungseinrichtung sowie die Lichtkonversionseinrichtung und/oder Beleuchtungseinrichtung mit dem entsprechenden Grundkörper.

Beleuchtungseinrichtungen sind in verschiedenen Ausführungen bekannt, beispielsweise sogenannte Entladungs- und Halogenlampen. Aus verschiedenen Gründen, beispielsweise um die Energieeffizienz zu erhöhen oder um Beleuchtungseinrichtungen mit geringem Platzbedarf vorzugsweise bei gleichzeitig hoher Leuchtdichte bereitzustellen, sind auf Laserlichtquellen basierende Beleuchtungseinrichtungen von zunehmendem Interesse. Diese sind in der Regel so aufgebaut, dass sie mindestens eine Laserlichtquelle, beispielsweise eine Laserdiode, umfassen sowie ein Lichtkonversionselement.

Das Lichtkonversionselement dient dazu, das Licht der Laserlichtquelle aufzunehmen und mit anderer Wellenlänge wieder abzugeben, weil das von der Laserlichtquelle bzw. von den Laserlichtquellen ausgestrahlte Licht in der Regel nicht den gewünschten, beispielsweise farbneutralen, "weißen" Farbort aufweist. Das Lichtkonversionselement ist in der Lage, nach Bestrahlen mit dem Licht der Laserlichtquelle bzw. der Laserlichtquellen dieses partiell oder vollständig in eine oder mehrere andere Wellenlängen bzw. in ein spezifisches Wellenlängenspektrum umzuwandeln. Das Licht hat beispielsweise eine Wellenlänge von 450nm bei einem blauer Laser und ist in der Regel monochromatisch. Durch additive Farbmischung von dem gestreuten Licht und dem konvertierten Licht wird hierbei ein Lichtbild mit einem gewünschten bzw. spezifizierten Farbort erzeugt.

Das Lichtkonversionselement wird auch als Konverter (beispielsweise Ce:YAG), Leuchtstoffelement oder (engl.) Phosphor bezeichnet, wobei der Begriff "Phosphor" hier nicht im Sinne des gleichnamigen chemischen Elements zu verstehen ist, sondern sich vielmehr auf die Eigenschaft dieser Stoffe bezieht, zu lumineszieren. Im Sinne der vorliegenden Offenbarung ist daher unter dem Begriff des "Phosphors", sofern nicht ausdrücklich anders ausgeführt, stets ein Leuchtstoff, nicht jedoch das gleichnamige chemische Element zu verstehen.

Besondere Bedeutung haben solche auf Laserlichtquellen basierenden Beleuchtungseinrichtungen insbesondere deshalb, weil auf diese Weise eine hohe Luminanz bzw. Leuchtdichte (engl.: luminance) erreicht werden kann, was insbesondere für Anwendungen im Automobilsektor relevant ist.

Oft ist es ein Ziel, eine besonders hohe Leuchtdichte auch und gerade bei geringer Laserleistung zu erreichen, um nicht nur eine hohe Leuchtdichte zu erzielen, sondern auch den Energieverbrauch möglichst gering zu halten. Dies kann erreicht werden, indem ein Lichtfleck einer nur geringen Abmessung, beispielsweise eines nur geringen Durchmessers, beispielsweise kleiner als 500 Mikrometer, jedoch mit entsprechend hoher Leuchtdichte erzeugt wird.

Der verwendete Phosphor kann einerseits in Transmission und andererseits auch in Remission (Reflexion) betrieben werden. In der Remissionsanwendung kann der Phosphor von der Rückseite gekühlt werden.

In der deutschen Offenlegungsschrift DE 10 2012 223 854 A1 ist eine Remote-Phosphor-Konvertereinrichtung beschrieben, welche eine Halterung sowie ein von dieser Halterung gehaltenes Konverterelement umfasst sowie ein Primärlicht-Abstrahlelement, das so ausgestaltet ist, dass ein von diesem emittiertes Primärlicht auf das Konverterelement gerichtet werden kann.

Die US-amerikanische Patentanmeldung US 2017/0210277 A1 beschreibt eine Halbleiter-LED-Vorrichtung, bei welcher die Luminanz in einer longitudinalen Richtung leicht abnimmt.

Die US-amerikanische Patentanmeldung US 2017/0210280 A1 beschreibt eine Scheinwerfervorrichtung für Fahrzeuge, die so ausgestaltet ist, dass unterschiedliche Lichtverteilungsmuster mit geringem Energieverbrauch eingestellt werden können.

In der US-amerikanischen Patentanmeldung US 2017/0198876 A1 ist eine Beleuchtungseinrichtung, die mit einem gekrümmten Lichtkonversionselement ausgestattet ist, sowie ein Fahrzeugscheinwerfer, der eine solche Beleuchtungseinrichtung umfasst, beschrieben.

Ein Verfahren zur Steuerung eines Kraftfahrzeugscheinwerfers und ein entsprechender Kraftfahrzeugscheinwerfer ist in der europäischen Patentanmeldung EP 3 184 884 A1 offenbart. Der Kraftfahrzeugscheinwerfer umfasst mindestens eine Laserdiode und ein der Laserdiode zugeordnetes Lichtkonversionselement. Bereiche des Lichtkonversionselements, die unterschiedlichen Bereiche des Lichtbildes entsprechen, sind von einem Lichtstrahl der Laserdiode periodisch und mit unterschiedlicher Intensität beleuchtbar, so dass die Beleuchtungsintensität in unterschiedlichen Bereichen des Lichtbildes durch die relative Beleuchtungsdauer und/oder durch die unterschiedlichen Lichtstärken der Laserdiode in diesen Bereichen einstellbar ist.

Die internationale Patentanmeldung WO 2017/133809 A1 beschreibt eine Beleuchtungsvorrichtung zur Emission von Beleuchtungslicht. Die Beleuchtungsvorrichtung umfasst eine LED zur Emission von LED-Strahlung und einen Laser zur Emission von Laserstrahlung sowie ein Leuchtstoffelement zur zumindest teilweise Konversion der LED- und der Laserstrahlung in ein Konversionslicht. Im Betrieb der Beleuchtungsvorrichtung überlappen die Bereiche auf dem Leuchtstoffelement, auf denen LED-Licht bzw. Laserlicht beleuchtet wird, zumindest teilweise.

Die europäische Patentanmeldung EP 3 203 140 A1 beschreibt eine Beleuchtungseinrichtung für ein Fahrzeug und ein zugehöriges Betriebsverfahren. Die Beleuchtungseinrichtung umfasst eine Pixel-Lichtquelle sowie ein von der Pixel-Leuchtquelle zumindest teilweise mit einer Lichtverteilung beleuchtbares anamorphotisches Element.

Die chinesische Patentanmeldung CN 106939991 A beschreibt einen Fahrzeugscheinwerfer, der auf der Laseranregung einer optischen Fluoreszenzfaser basiert, umfassend ein Lasermodul, eine optische Faser und eine optische Fluoreszenzfaser. Auf diese Weise wird ein Fahrzeugscheinwerfer mit einem kompakten Aufbau bereitgestellt.

Die internationale Patentanmeldung WO 2017/111405 A1 beschreibt eine Phosphorplattenanordnung, eine Anordnung zum Aussenden von Licht sowie einen Fahrzeugscheinwerfer, der diese Anordnungen umfasst.

Die internationale Patentanmeldung WO 2017/104167 A1 beschreibt eine Beleuchtungsvorrichtung und einen Fahrzeugscheinwerfer. Die Beleuchtungsvorrichtung umfasst eine Vorrichtung zum Aussenden von Licht mit einem Leuchtstoff, der Licht emittiert, wenn er von Licht des Laserelements angeregt wird sowie einen Spiegel, der beweglich ist und sich kontinuierlich nach einer vorbestimmten Routine bewegt.

Es hat sich allerdings herausgestellt, dass die bekannten Beleuchtungseinrichtungen im Hinblick auf eine Ausrichtung und/oder Zentrierung eines Leuchtspots in Bezug zu einer sekundären Optik weiter verbesserungswürdig sind.

Es ist daher eine Aufgabe der Erfindung, ein Leuchtspot mit hoher Genauigkeit zu einer sekundären Optik auszurichten bzw. zu zentrieren, wobei dies vorzugsweise für hohe oder sehr hohe Leuchtdichten und vorzugsweise für weißes Licht ermöglicht werden soll. Hierfür sollen eine Beleuchtungseinrichtung, eine dafür geeignete Lichtkonversionseinrichtung, ein dafür geeigneter Grundkörper und entsprechende Verfahren zur Herstellung und/oder Bearbeitung bereitgestellt werden. Ein Aspekt der Aufgabe ist insbesondere eine hohe Genauigkeit, d.h. geringe Toleranzen, und eine Vermeidung von Toleranzverkettungen.

Diese Aufgabe wird durch die Gegenstände der unabhängigen Ansprüche gelöst. Vorteilhafte Weiterbildungen der Erfindung sind Gegenstände der abhängigen Ansprüche.

Erfindungsgemäß wird eine Lichtkonversionseinrichtung angegeben, welche einen Grundkörper, der insbesondere als Kühlkörper ausgebildet ist, und ein mittelbar oder unmittelbar auf der Vorderseite des Grundkörpers aufgebrachtes Lichtkonversionselement umfasst. Das Lichtkonversionselement ist mit seiner Rückseite der Vorderseite des Grundkörpers zugewandt, während die Vorderseite des Lichtkonversionselements dem Grundkörper abgewandt ist.

Die dem Grundkörper abgewandte Vorderseite des Lichtkonversionselements ist dazu ausgelegt, mit Primärlicht beleuchtet zu werden und Sekundärlicht einer anderen Wellenlänge abzugeben. Das Lichtkonversionselement ist demnach dazu eingerichtet, auf seiner Vorderseite mit Primärlicht beleuchtet zu werden und das Sekundärlicht wiederum auf der Vorderseite abzugeben, d.h. das Lichtkonversionselement ist für einen Remissionsbetrieb (Reflexionsbetrieb) ausgelegt. Aufgrund dieser Remissionsanordnung kann das Lichtkonversionselement durch einen als Kühlkörper ausgebildeten Grundkörper von der Rückseite gekühlt werden.

Erfindungsgemäß weist der Grundkörper einen Indikator zur Positionierung/Orientierung Lichtkonversionselements auf dem Grundkörper auf und/oder einen Indikator zur Positionierung/Orientierung des Grundkörpers zusammen mit dem darauf aufgebrachten Lichtkonversionselement.

Der Grundkörper weist also einerseits vorzugsweise einen Indikator zur Positionierung und/oder Orientierung des Lichtkonversionselements auf dem Grundkörper auf, so dass das auf dem Grundkörper aufgebrachte Lichtkonversionselement mittels dieses Indikators positioniert/orientiert ist. Der Indikator für das Lichtkonversionselement kann auch als Halterung ausgebildet sein und das Lichtkonversionselement zugleich halten und/oder fixieren.

Andererseits kann der Grundkörper alternativ oder zusätzlich zumindest einen Indikator, vorzugsweise mehrere Indikatoren, zur Positionierung und/oder Orientierung des Grundkörpers zusammen mit dem darauf aufgebrachten Lichtkonversionselement aufweisen. Dieser Indikator bzw. diese Indikatoren dienen also der Positionierung und/oder Orientierung des Grundkörpers selbst bzw. der Positionierung und/oder Orientierung des Grundkörpers gegenüber einem anderweitigen, beispielsweise externen, also beispielsweise nicht der Lichtkonversionseinrichtung zugehörigen Bauteil zum Halten des Grundkörpers, auf welchem der Grundkörper beispielsweise befestigt wird.

Mit einem Indikator zur Positionierung/Orientierung des Lichtkonversionselements auf dem Grundkörper und/oder einem Indikator zur Positionierung/Orientierung des Grundkörpers zusammen mit dem darauf aufgebrachten Lichtkonversionselement, welche jeweils beispielsweise als eine in dem Grundkörper integrierte Struktur ausgebildet sein können, kann in vorteilhafter Weise eine Zentrierung des Leuchtspots gegenüber einer Sekundäroptik erfolgen, wobei insbesondere eine Toleranzverkettung verschiedener Komponenten vermieden wird. Es wird somit eine Lösung angegeben, den Leuchtspot mit hoher Genauigkeit zu einer sekundären Optik auszurichten und/oder zu zentrieren.

Mit der Erfindung wird es somit ermöglicht, dass ein Lichtkonversionselement relativ zu einem Indikator aktiv oder passiv justiert werden kann. Wie weiter unten noch näher ausgeführt wird, kann beispielsweise eine Wärmesenke als Grundkörper verwendet werden, deren Vorder- und/oder Rückseite mit Markierungen und/oder Vertiefungen/Erhebungen realisiert sind, so dass das Lichtkonversionselement vorzugsweise zentrisch zu einer Markierung/Vertiefung/Erhebung passiv oder aktiv justiert werden kann.

Mit der erfindungsgemäßen Lichtkonversionseinrichtung, welche insbesondere in einer Beleuchtungseinrichtung mit einem Laser zur Bestrahlung der Lichtkonversionselemente mit dem Primärlicht zum Einsatz kommen kann, wie weiter unten noch näher ausgeführt wird, kann eine hohe Luminanz bzw. Leuchtdichte (engl.: luminance) erreicht werden, was insbesondere für Anwendungen im Automobilsektor, im Flugzeugsektor, in der medizinischen Beleuchtung und im generellen Beleuchtungssektor, wie Bühnen- oder Suchscheinwerfer, von Bedeutung sein kann. Es ist somit möglich, eine besonders hohe Leuchtdichte auch und gerade bei geringer Laserleistung zu erreichen, um nicht nur eine hohe Leuchtdichte zu erzielen, sondern auch den Energieverbrauch möglichst gering zu halten. Hierzu kann auch ein Lichtfleck einer nur geringen Abmessung vorgesehen sein, beispielsweise eines nur geringen Durchmessers, jedoch mit entsprechend hoher Leuchtdichte.

Das auf dem Grundkörper aufgebrachte Lichtkonversionselement kann unmittelbar oder mittelbar auf dem Grundkörper angeordnet sein. Im Fall, dass das Lichtkonversionselement mittelbar auf dem Grundkörper aufgebracht ist, kann beispielsweise die Lichtkonversionseinrichtung ein auf dem Grundkörper aufgebrachtes Zwischenelement umfassen, auf welchem wiederum das Lichtkonversionselement angeordnet ist. Ein solches Zwischenelement kann auch als Ausrichtungselement ausgebildet sein, derart dass damit eine Ausrichtung des Lichtkonversionselements relativ zum Primärlicht und/oder eine Ausrichtung des Sekundärlichts relativ zu einer nachgeordneten Optik möglich ist. Vorzugsweise ist das Lichtkonversionselement allerdings unmittelbar auf dem Grundkörper angeordnet.

Der Indikator zur Positionierung/Orientierung des Lichtkonversionselements auf dem Grundkörper kann in dem Grundkörper integriert sein oder als separates Element auf dem Grundkörper angeordnet sein. Vorzugsweise ist der Indikator zur Positionierung/Orientierung des Lichtkonversionselements allerdings integral in dem Grundkörper ausgebildet. Der Indikator wird vorzugsweise durch das Material des Grundkörpers selbst gebildet. Der Grundkörper mit dem Indikator zur Positionierung/Orientierung des Lichtkonversionselements kann monolithisch ausgebildet sein.

Auch der Indikator zur Positionierung/Orientierung des Grundkörpers zusammen mit dem darauf aufgebrachten Lichtkonversionselement kann in den Grundkörper integriert sein oder als separates Element auf dem Grundkörper angeordnet sein, ist aber vorzugsweise integral mit dem Grundkörper ausgebildet. Der Indikator wird vorzugsweise durch das Material des Grundkörpers selbst gebildet. Der Grundkörper mit dem Indikator zur Positionierung/Orientierung des Grundkörpers kann wiederum monolithisch ausgebildet sein.

Vorzugsweise ist der Indikator zur Positionierung/Orientierung des Lichtkonversionselements auf dem Grundkörper und/oder der Indikator zur Positionierung/Orientierung des Grundkörpers zusammen mit dem darauf aufgebrachten Lichtkonversionselement mit einer Genauigkeit von kleiner 500 Mikrometern, vorzugsweise kleiner 100 Mikrometern, besonders bevorzugt kleiner 50 Mikrometern ausgebildet. Insbesondere ist die Toleranz des Indikators oder der Indikatoren bevorzugt kleiner als die angegebenen Werte. Die Erfindung betrifft somit auch ein Set mit einer Mehrzahl von Lichtkonversionseinrichtungen, jeweils insbesondere wie vorstehend beschrieben, wobei die Positionsdifferenz des Indikators oder der Indikatoren zwischen den einzelnen Lichtkonversionseinrichtungen der Mehrzahl von Lichtkonversionseinrichtungen kleiner ist als die vorstehend beschriebenen Werte.

In einer Ausführungsform der Erfindung ist der Indikator zur Positionierung/Orientierung des Lichtkonversionselements als Markierung auf oder in dem Grundkörper ausgebildet. Die Markierung kann beispielsweise aufgedruckt sein. Vorzugsweise ist die Markung jedoch integral in das Material eingebracht, beispielsweise durch Laserablation oder Ätzen.

Weiterhin kann der Indikator zur Positionierung/Orientierung des Lichtkonversionselements als Erhebung oder als Vertiefung in dem Grundkörper ausgebildet sein. Ein solche Erhebung oder Vertiefung kann beispielsweise durch Anordnen zusätzlicher Elemente auf dem Grundkörper erzeugt werden. Vorzugsweise ist die Erhebung oder Vertiefung jedoch integral in dem Material des Grundkörpers ausgebildet, beispielsweise ab Herstellung oder nachträglich durch Prägen.

Hinsichtlich des zumindest einen Indikators zur Positionierung/Orientierung des Grundkörpers zusammen mit dem darauf aufgebrachten Lichtkonversionselement bzw. dem Indikator zur Positionierung/Orientierung des Grundkörpers selbst bzw. gegenüber einem Bauteil zum Halten des Grundkörpers kommen ebenfalls die vorstehend benannten Ausführungen als Markierung und/oder Erhebung oder Vertiefung in Betracht. Vorzugsweise ist der Indikator zur Positionierung/Orientierung des Grundkörpers als Kavität in dem Grundkörper ausgebildet. Eine Kavität kann als Vertiefung ausgebildet sein, insbesondere aber als Durchgangskavität, insbesondere quer oder senkrecht zur Vorderseite des Grundkörpers. Mit anderen Worten kann eine Durchgangskavität sich quer oder senkrecht zur Vorderseite des Grundkörpers in dem oder durch den Grundkörper erstrecken.

Eine Kavität, insbesondere eine Durchgangskavität, welche quer oder senkrecht zur Vorderseite des Grundkörpers in dem oder durch den Grundkörper verläuft kann dabei beispielsweise seitlich nach außen geöffnet sein. Andererseits kann eine Kavität, insbesondere eine Durchgangskavität, welche quer oder senkrecht zur Vorderseite des Grundkörpers in dem oder durch den Grundkörper verläuft, auch seitlich nach außen geschlossen sein, so dass die Kavität insbesondere als Loch oder Bohrung ausgebildet sein kann. In einer Ausführungsform der Erfindung sind mehrere Kavitäten in dem Grundkörper vorgesehen, wobei zumindest eine Kavität seitlich nach außen geöffnet ist und eine Kavität seitlich nach außen geschlossen ist. So können beispielsweise vier Kavitäten vorgesehen sein, wobei zwei davon seitlich nach außen geöffnet sind und die anderen zwei seitlich nach außen geschlossen sind.

Unabhängig davon wie der Indikator oder die Indikatoren genau ausgebildet sind, kann der Indikator zur Positionierung/Orientierung des Lichtkonversionselements auf dem Grundkörper und/oder der Indikator zur Positionierung/Orientierung des Grundkörpers zusammen mit dem darauf aufgebrachten Lichtkonversionselement dazu eingerichtet sein, eine Zentrierung des von dem Lichtkonversionselement abgegebenen Sekundärlichts gegenüber einer dem Lichtkonversionselement nachgeordneten Optik zu ermöglichen.

Die Erfindung betrifft ferner eine Beleuchtungseinrichtung mit einer Lichtkonversionseinrichtung, insbesondere wie vorstehend beschrieben, d.h. mit einem Grundkörper und einem auf dem Grundkörper aufgebrachten Lichtkonversionselement, und ferner einer Lichtabgabeeinheit, welche dazu eingerichtet ist, das Primärlicht zur Beleuchtung der Vorderseite des Lichtkonversionselements abzugeben. Die Lichtabgabeeinheit ist demnach dazu eingerichtet, das Lichtkonversionselement mit dem Primärlicht zu bestrahlen, wobei die Lichtabgabeeinheit so angeordnet ist bzw. dazu eingerichtet ist, das Lichtkonversionselement auf seiner Vorderseite mit dem Primärlicht zu bestrahlen. Der Grundkörper weist, wie vorstehend für die Lichtkonversionseinrichtung beschrieben, einen Indikator zur Positionierung/Orientierung des auf dem Grundkörper aufgebrachten Lichtkonversionselements auf dem Grundkörper auf und/oder zumindest einen Indikator zur Positionierung/Orientierung des Grundkörpers zusammen mit dem darauf aufgebrachten Lichtkonversionselement, wobei diesbezüglich auf die vorstehenden Ausführungen verwiesen wird.

Die Beleuchtungseinrichtung umfasst vorzugsweise eine dem Lichtkonversionselement nachgeordnete Optik zur Erfassung, insbesondere zur Formung, des Sekundärlichts, welches von dem Lichtkonversionselement abgegeben werden kann. In diesem Fall ist der Indikator zur Positionierung/Orientierung des Lichtkonversionselements auf dem Grundkörper und/oder der Indikator zur Positionierung/Orientierung des Grundkörpers zusammen mit dem darauf aufgebrachten Lichtkonversionselement vorzugsweise dazu eingerichtet, eine Zentrierung des von dem Lichtkonversionselement abgegebenen Sekundärlichts gegenüber der dem Lichtkonversionselement nachgeordneten Optik zu ermöglichen.

Die das Primärlicht abgebende Lichtabgabeeinheit kann eine Laserlichtquelle umfassen oder als solche ausgebildet sein. Es ist allerdings nicht zwingend eine Laserlichtquelle umfasst, es kann beispielsweise auch nur ein Lichtleiter umfasst sein, welcher das Primärlicht abgibt, wobei der Lichtleiter seinerseits mit einer Laserlichtquelle verbunden sein kann, um das Licht in den Lichtleiter einzukoppeln. Die Beleuchtungseinrichtung umfasst demnach zumindest eine Lichtabgabeeinheit, welche dazu eingerichtet ist, das Primärlicht abzugeben.

In einer Variante kann die Lichtabgabeeinheit eine Lichtquelle, insbesondere eine Laserlichtquelle, umfassen, welche dazu eingerichtet ist, das Primärlicht zur Beleuchtung des Lichtkonversionselements abzugeben.

Alternativ oder zusätzlich kann auch vorgesehen sein, dass die Lichtabgabeeinheit einen Lichtleiter, insbesondere einen Faserlichtleiter, umfasst, welcher dazu eingerichtet ist, das Primärlicht zur Beleuchtung des Lichtkonversionselements abzugeben.

Die Lichtabgabeeinheit der Beleuchtungseinrichtung ist vorzugsweise derart angeordnet, dass das Primärlicht seitlich auf das Lichtkonversionselement eingestrahlt wird, wobei das Primärlicht insbesondere entlang einer optischen Achse eingestrahlt wird, welche zu einer Normalachse des Lichtkonversionselements und/oder zu einer optischen Achse des Sekundärlichts einen Winkel von größer als 30 Grad, vorzugsweise größer als 45 Grad, besonders bevorzugt von größer als 60 Grad, aufweist.

Die Lichtabgabeeinheit kann ferner dazu eingerichtet und/oder derart angeordnet sein, dass die Primärlichtempfangsfläche, innerhalb derer das Lichtkonversionselement mit dem Primärlicht beleuchtet wird, kleiner ist als 1 Quadratmillimeter, vorzugsweise kleiner ist als 0,5 Quadratmillimeter, besonders bevorzugt kleiner ist als 0,2 Quadratmillimeter.

Die Lichtabgabeeinheit, welche das Primärlicht abgibt, weist vorzugsweise eine Strahlungsleistung von mindestens 0,5W auf. Ferner kann vorgesehen sein, dass das Sekundärlicht eine Leuchtdichte von mindestens 50cd/mm² aufweist.

Die Erfindung betrifft ferner einen Grundkörper für eine Lichtkonversionseinrichtung und/oder eine Beleuchtungseinrichtung, insbesondere wie vorstehend beschrieben, wobei der Grundkörper insbesondere als Kühlkörper ausgebildet ist, wobei der Grundkörper eine Vorderseite aufweist, welche dazu ausgebildet ist ein Lichtkonversionselement auf den Grundkörper aufzubringen.

Der Grundkörper weist vorzugsweise einen Indikator zur Positionierung/Orientierung des Lichtkonversionselements auf dem Grundkörper auf und/oder einen Indikator zur Positionierung/Orientierung des Grundkörpers selbst bzw. des Grundkörpers gegenüber einem, insbesondere externen, Bauteil beispielsweise zum Halten des Grundkörpers.

Für den Indikator oder die Indikatoren wird insbesondere auf die vorstehenden Ausführungen zur Lichtkonversionseinrichtung bzw. Beleuchtungseinrichtung verwiesen. Insbesondere kann ein Indikator demnach integral bzw. monolithisch in dem Grundkörper ausgebildet sein, wobei eine Genauigkeit von kleiner 500 Mikrometern, vorzugsweise kleiner 100 Mikrometern, besonders bevorzugt kleiner 50 Mikrometern vorgesehen sein kann.

Der Indikator zur Positionierung/Orientierung des Lichtkonversionselements kann beispielsweise als Markierung an dem Grundkörper ausgebildet sein und/oder als Erhebung oder als Vertiefung an dem Grundkörper ausgebildet sein, wobei wiederum auf die vorstehenden Ausführungen verwiesen wird.

Der zumindest eine Indikator zur Positionierung/Orientierung des Grundkörpers selbst bzw. gegenüber einem Bauteil zum Halten des Grundkörpers kann als Kavität in dem Grundkörper ausgebildet sein, insbesondere als Durchgangskavität quer oder senkrecht zur Vorderseite des Grundkörpers. Eine Kavität oder mehrere Kavitäten, insbesondere eine Durchgangskavität, welche beispielsweise quer oder senkrecht zur Vorderseite des Grundkörpers in dem oder durch den Grundkörper verläuft, kann seitlich nach außen geöffnet sein und/oder seitlich allseits geschlossen sein, wobei diesbezüglich wiederum auf die vorstehenden Ausführungen verwiesen wird.

Die Erfindung betrifft ferner ein Verfahren zur Bearbeitung eines Grundkörpers, welcher insbesondere als Kühlkörper ausgebildet ist. Bei dem Verfahren wird ein Grundkörper bereitgestellt und es wird ein Indikator zur Positionierung/Orientierung eines Lichtkonversionselements auf dem Grundkörper und/oder ein Indikator zur Positionierung/Orientierung des Grundkörpers selbst bzw. gegenüber einem Bauteil zum Halten des Grundkörpers ausgebildet.

Vorzugsweise wird der Indikator zur Positionierung/Orientierung des Lichtkonversionselements mit dem Grundkörper integral ausgebildet, insbesondere mit einer Genauigkeit von kleiner 500 Mikrometern, vorzugsweise kleiner 100 Mikrometern, besonders bevorzugt kleiner 50 Mikrometern.

Auch der Indikator zur Positionierung/Orientierung des Grundkörpers gegenüber einem Bauteil zum Halten des Grundkörpers wird vorzugsweise integral in dem Grundkörper ausgebildet, insbesondere mit einer Genauigkeit von kleiner 500 Mikrometern, vorzugsweise kleiner 100 Mikrometern, besonders bevorzugt kleiner 50 Mikrometern.

Ein Indikator zur Positionierung/Orientierung des Lichtkonversionselements kann etwa als Markierung in dem Grundkörper ausgebildet werden, beispielsweise mittels Laserbearbeitung.

Andererseits kann ein Indikator zur Positionierung/Orientierung des Lichtkonversionselements auch als Erhebung oder als Vertiefung in dem Grundkörper ausgebildet werden, beispielsweise mittels eines Prägeverfahrens.

Der zumindest eine Indikator zur Positionierung/Orientierung des Grundkörpers gegenüber einem Bauteil zum Halten des Grundkörpers kann als Kavität in dem Grundkörper ausgebildet werden, insbesondere als Durchgangskavität quer oder senkrecht zur Vorderseite des Grundkörpers in dem Grundkörper, wobei eine Kavität beispielsweise mittels Bohren eingefügt wird .

Eine Kavität kann insbesondere derart eingebacht werden, dass sie quer oder senkrecht zur Vorderseite des Grundkörpers in dem Grundkörper verläuft. Außerdem kann eine Kavität derart eingebracht werden, dass sie seitlich nach außen geöffnet ist oder dass sie seitlich allseits geschlossen ist. Wie weiter oben beschrieben können auch mehrere Kavitäten eingebracht werden, wobei zumindest eine davon derart eingebracht wird, dass sie seitlich geöffnet ist und zumindest eine andere derart eingebracht wird, dass sie seitlich allseits geschlossen ist.

Die Erfindung betrifft weiterhin ein Verfahren zur Herstellung einer Lichtkonversionseinrichtung. Bei diesem Verfahren wird ein Grundkörper, welcher insbesondere als Kühlkörper ausgebildet ist, bereitgestellt, wobei der Grundkörper einen Indikator zur Positionierung/Orientierung eines Lichtkonversionselements auf dem Grundkörper aufweist. Bei dem Verfahren wird dann ein Lichtkonversionselement auf den Grundkörper aufgebracht, insbesondere mittels des Indikators zur Positionierung/Orientierung eines Lichtkonversionselements auf dem Grundkörper.

Die Erfindung betrifft weiterhin ein Verfahren zur Herstellung einer Beleuchtungseinrichtung. Hierbei wird eine Lichtkonversionseinrichtung mit einem Grundkörper und einem auf einer Vorderseite des Grundkörpers aufgebrachten Lichtkonversionselement bereitgestellt, wobei der Grundkörper zumindest einen Indikator zur Positionierung/Orientierung des Grundkörpers zusammen mit dem darauf aufgebrachten Lichtkonversionselement aufweist. Bei dem Verfahren wir dann das Lichtkonversionselement, insbesondere das von dem Lichtkonversionselement abgebbare Sekundärlicht, gegenüber einer dem Lichtkonversionselement nachgeordneten Optik mittels des Indikators zur Positionierung/Orientierung des Grundkörpers zusammen mit dem darauf aufgebrachten Lichtkonversionselement ausgerichtet, insbesondere zentriert.

Die Erfindung wird nachfolgend anhand einiger Figuren näher erläutert. Dabei zeigen:
- Fig. 1: eine aus dem Stand der Technik bekannte Beleuchtungseinrichtung, bei der ein Lichtkonversionselement (Konverter) im Transmissionsbetrieb zum Einsatz kommt;
- Fig. 2: eine Beleuchtungseinrichtung, bei der ein Konverter im Remissionsbetrieb zum Einsatz kommt;
- Fig. 3,4: eine Draufsicht und eine seitliche Schnittansicht einer ersten Ausführungsform einer Lichtkonversionseinrichtung mit einem Grundkörper und einem darauf angeordneten Lichtkonversionselement;
- Fig. 5,6: eine Draufsicht und eine seitliche Schnittansicht einer zweiten Ausführungsform einer Lichtkonversionseinrichtung mit einem Grundkörper und einem darauf angeordneten Lichtkonversionselement; und
- Fig. 7: eine Fotografie einer Lichtkonversionseinrichtung mit einem Grundkörper und einem darauf angeordneten Lichtkonversionselement.

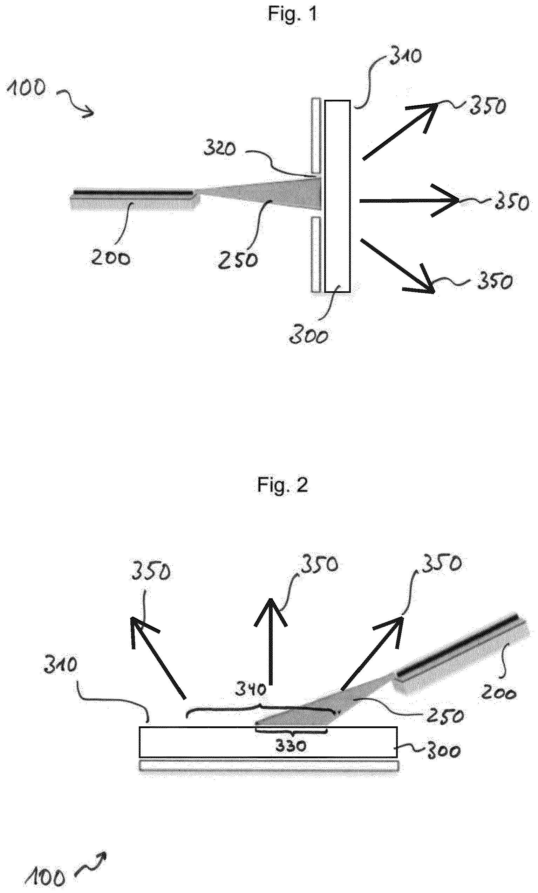

Fig. 1 zeigt eine aus dem Stand der Technik bekannte Beleuchtungseinrichtung 100, welche für den Transmissionsbetrieb ausgelegt ist. Die Beleuchtungseinrichtung 100 umfasst eine als Laserdiode ausgebildete Lichtabgabeeinheit 200, mit welcher Primärlicht 250, beispielsweise blaues Licht, auf die Rückseite 320 eines Lichtkonversionselements 300 gestrahlt wird. Das Lichtkonversionselements 300 empfängt demnach das Primärlicht 250 auf der Rückseite 320 und gibt auf der Vorderseite 310 Sekundärlicht 350 ab.

Fig. 2 zeigt eine ähnliche Beleuchtungseinrichtung 100, welche jedoch für den Remissionsbetrieb (Reflexionsbetrieb) ausgelegt ist. Hier strahlt die Lichtabgabeeinheit 200 das Primärlicht 250 auf die Vorderseite 310 des Lichtkonversionselements 300, wobei die Vorderseite im Bereich einer Primärlichtempfangsfläche 330 beleuchtet wird. Das Lichtkonversionselement 300 gibt auf der Vorderseite 310 im Bereich einer Sekundärlichtabgabefläche 340 das Sekundärlicht 350 ab.

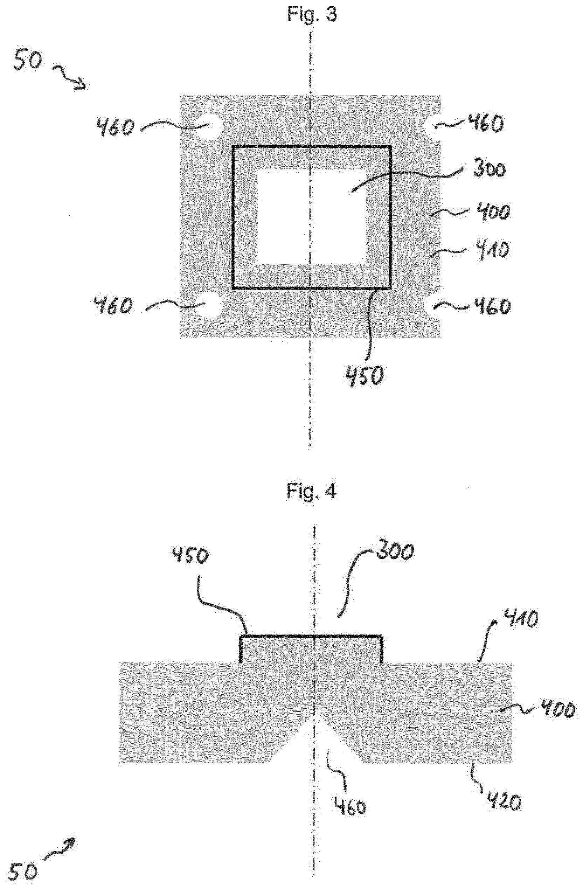

Fig. 3 und 4 zeigen eine erste Ausführungsform einer Lichtkonversionseinrichtung 50, welche beispielsweise für eine Beleuchtungseinrichtung 100 verwendet werden kann, wobei die Lichtkonversionseinrichtung 50 einen als Kühlkörper ausgebildeten Grundkörper 400 umfasst, auf dem ein Lichtkonversionselement 300 aufgebracht ist.

Der Grundkörper 400 weist auf seiner Vorderseite 410 einen Indikator 450 zur Positionierung/Orientierung des Lichtkonversionselements 300 auf dem Grundkörper 400 auf, wobei der Indikator 450 in diesem Beispiel als eine Erhebung an dem Grundkörper 400, genauer gesagt als eine Erhebung in der Vorderseite 410 des Grundkörpers 400, ausgebildet ist. Der in diesem Beispiel als Erhebung ausgebildete Indikator 450 ist zentral auf der Vorderseite 410 des Grundkörpers angeordnet, so dass das entsprechende bzw. mittels dem Indikator 450 aufgebrachte Lichtkonversionselement 300 ebenfalls zentral auf der Vorderseite 410 des Grundkörpers 400 angeordnet ist.

Der Grundkörper 400 weist außerdem Indikatoren 460 zur Positionierung/Orientierung des Grundkörpers 400 zusammen mit dem darauf aufgebrachten Lichtkonversionselement 300 auf, wobei diese auch als Indikatoren 460 zur Positionierung/Orientierung des Grundkörpers 400 selbst bzw. des Grundkörpers 400 gegenüber einem Bauteil zum Halten des Grundkörpers 400 bezeichnet werden können. Diese Indikatoren 460 sind jeweils als Durchgangskavität senkrecht zur Vorderseite 410 bzw. Rückseite 420 des Grundkörpers ausgebildet. Die Durchgangskavitäten erstrecken sich demnach durch den Grundkörper 400 hindurch von der Vorderseite 410 bis zur Rückseite 420 des Grundkörpers 400. Wie in Fig. 3 zu sehen befinden sich dabei auf einer Seite des Grundkörpers Indikatoren 460, in diesem Beispiel zwei Stück, welche seitlich nach außen geöffnet sind, während sich gegenüberliegend auf der anderen Seite des Grundkörpers 400 Indikatoren 460 befinden, welche seitlich allseits geschlossen sind, in diesem Beispiel wiederum zwei Stück. In Fig. 4 ist zu sehen, dass sich außerdem ein hier als Kavität bzw. Vertiefung ausgebildeter Indikator 460 auf der Rückseite 420 des Grundkörpers 400 befindet, wobei dieser Indikator 460 insbesondere zentrisch angeordnet ist.

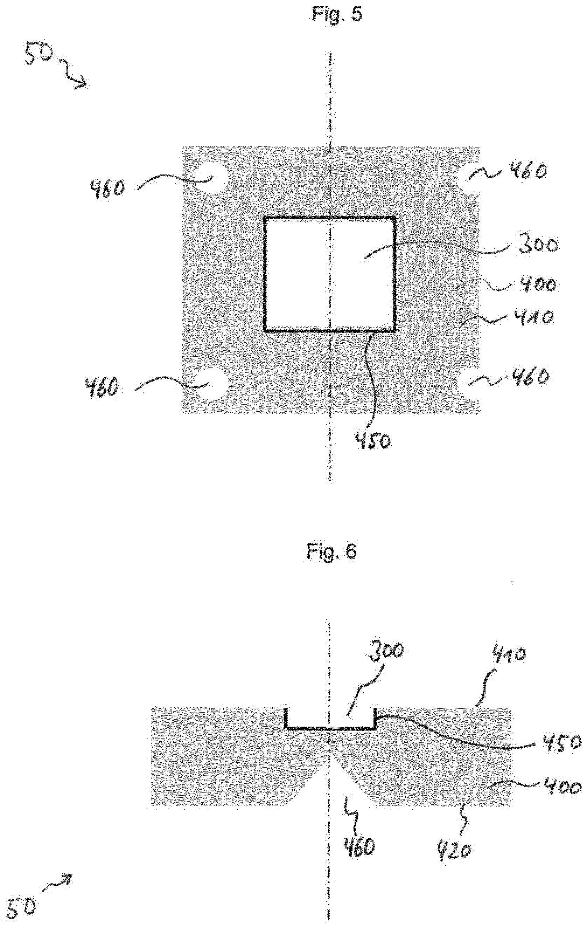

Fig. 5 und 6 zeigen eine zweite Ausführungsform einer Lichtkonversionseinrichtung 50, wobei die Lichtkonversionseinrichtung 50 einen als Kühlkörper ausgebildeten Grundkörper 400 umfasst, auf dem ein Lichtkonversionselement 300 aufgebracht ist. Für diese Ausführungsform gelten im Wesentlichen die vorstehenden Ausführungen zur ersten Ausführungsform. Abweichend davon ist ein auf der Vorderseite 410 des Grundkörpers 400 vorgesehener Indikator 450 zur Positionierung/Orientierung des Lichtkonversionselements 300 auf dem Grundkörper 400, hier als Vertiefung in dem Grundkörper 400, genauer gesagt als Vertiefung in der Vorderseite 410 des Grundkörpers 400, ausgebildet. Zugleich dient der Indikator 450 auch als Halterung für das Lichtkonversionselement 300. Es kann etwa vorgesehen sein, dass das Lichtkonversionselement 300 passgenau in die Vertiefung eingelassen ist.

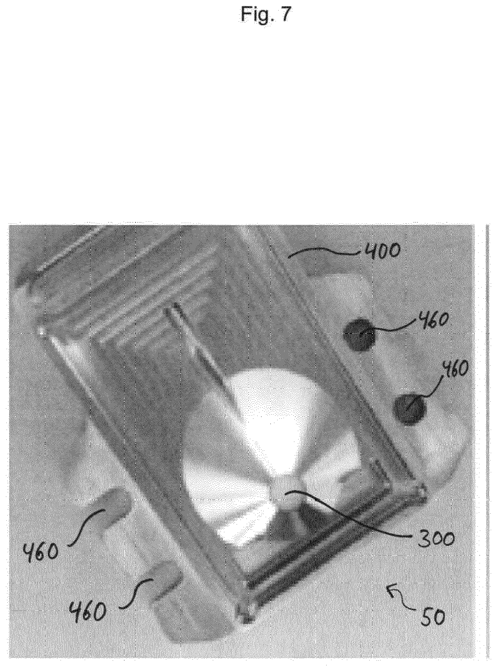

Mittels der in den beiden genannten Ausführungsformen einer Lichtkonversionseinrichtung 50 vorgesehenen Indikatoren 450, 460 kann eine Zentrierung des von dem jeweiligen Lichtkonversionselement 300 abgegebenen Sekundärlichts gegenüber einer dem Lichtkonversionselement 300 nachgeordneten Optik ermöglicht werden. Der Konverter 300 kann dazu insbesondere zentrisch zur unteren Markierung/Vertiefung 460 passiv oder aktiv justiert werden. Die Markierungen und oder Vertiefungen können beispielsweise durch ein einfaches Prägeverfahren realisiert werden. In Fig. 7 ist eine Fotografie einer gemäß der vorliegenden Erfindung hergestellten Lichtkonversionseinrichtung 50 zu sehen.

Es ist für den Fachmann ersichtlich, dass die vorstehend beschriebenen Ausführungsformen beispielhaft zu verstehen sind und die Erfindung nicht auf diese beschränkt ist, sondern in vielfältiger Weise variiert werden kann, ohne den Schutzbereich der Ansprüche zu verlassen. Ferner ist ersichtlich, dass die Merkmale unabhängig davon, ob sie in der Beschreibung, den Ansprüchen, den Figuren oder anderweitig offenbart sind, auch einzeln wesentliche Bestandteile der Erfindung definieren, selbst wenn sie zusammen mit anderen Merkmalen gemeinsam beschrieben sind und somit als unabhängig voneinander offenbart angesehen werden können. Die Beschreibung von Merkmalen eines Ausführungsbeispiels gilt jeweils auch für die anderen Ausführungsbeispiele.

## Patentansprüche

1. Lichtkonversionseinrichtung (50) umfassend
einen Grundkörper (400), welcher insbesondere als Kühlkörper ausgebildet ist, wobei der Grundkörper (400) eine Vorderseite (410) aufweist und
ein auf der Vorderseite (410) des Grundkörpers (400) aufgebrachtes Lichtkonversionselement (300),
wobei das Lichtkonversionselement (300) eine dem Grundkörper (400) abgewandte Vorderseite (310) aufweist und dazu eingerichtet ist, auf der Vorderseite (310) mit Primärlicht (250) beleuchtet zu werden und Sekundärlicht (350) mit einer anderen Wellenlänge auf der Vorderseite (310) abzugeben,
wobei der Grundkörper (400) einen Indikator (450) zur Positionierung/Orientierung des auf dem Grundkörper (400) aufgebrachten Lichtkonversionselements (300) auf dem Grundkörper (400) aufweist, und/oder
wobei der Grundkörper (400) zumindest einen Indikator (460) zur Positionierung/Orientierung des Grundkörpers (400) zusammen mit dem darauf aufgebrachten Lichtkonversionselement (300) aufweist.

2. Lichtkonversionseinrichtung (50) nach dem vorstehenden Anspruch,
wobei der Indikator (450) zur Positionierung/Orientierung des Lichtkonversionselements (300) auf dem Grundkörper (400) integral mit dem Grundkörper (400) ausgebildet ist, insbesondere mit einer Genauigkeit von kleiner 500 Mikrometern, vorzugsweise kleiner 100 Mikrometern, besonders bevorzugt kleiner 50 Mikrometern, und/oder
wobei der Indikator (460) zur Positionierung/Orientierung des Grundkörpers (400) zusammen mit dem darauf aufgebrachten Lichtkonversionselement (300) integral mit dem Grundkörper (400) ausgebildet ist, insbesondere mit einer Genauigkeit von kleiner 500 Mikrometern, vorzugsweise kleiner 100 Mikrometern, besonders bevorzugt kleiner 50 Mikrometern und/oder
wobei der Indikator (450) zur Positionierung/Orientierung des Lichtkonversionselements (300) auf dem Grundkörper (400) und/oder der Indikator (460) zur Positionierung/Orientierung des Grundkörpers (400) zusammen mit dem darauf aufgebrachten Lichtkonversionselement (300) dazu eingerichtet ist, eine Zentrierung des von dem Lichtkonversionselement (300) abgegebenen Sekundärlichts (350) gegenüber einer dem Lichtkonversionselement (300) nachgeordneten Optik zu ermöglichen.

3. Lichtkonversionseinrichtung (50) nach einem der vorstehenden Ansprüche,
wobei der Indikator (450) zur Positionierung/Orientierung des Lichtkonversionselements (300) als Markierung an dem Grundkörper (400) ausgebildet ist, und/oder
wobei der Indikator (450) zur Positionierung/Orientierung des Lichtkonversionselements (300) als Erhebung oder als Vertiefung in dem Grundkörper (400) ausgebildet ist.

4. Lichtkonversionseinrichtung (50) nach einem der vorstehenden Ansprüche,
wobei der zumindest eine Indikator (460) zur Positionierung/Orientierung des Grundkörpers (400) zusammen mit dem darauf aufgebrachten Lichtkonversionselement (300) als Kavität in dem Grundkörper (400) ausgebildet ist, insbesondere als Durchgangskavität quer oder senkrecht zur Vorderseite (410) des Grundkörpers (400), und/oder
wobei eine Kavität, insbesondere eine Durchgangskavität, quer oder senkrecht zur Vorderseite (410) des Grundkörpers (400) in dem Grundkörper (400) verläuft und seitlich nach außen geöffnet ist, und/oder
wobei eine Kavität, insbesondere eine Durchgangskavität, quer oder senkrecht zur Vorderseite (410) des Grundkörpers (400) in dem Grundkörper (400) verläuft und seitlich allseits geschlossen ist.

5. Beleuchtungseinrichtung umfassend
eine Lichtkonversionseinrichtung (50) mit einem Grundkörper (400) und einem auf einer Vorderseite (410) des Grundkörpers (400) aufgebrachten Lichtkonversionselement (300), insbesondere nach einem der vorstehenden Ansprüche,
wobei das Lichtkonversionselement (300) eine dem Grundkörper (400) abgewandte Vorderseite (310) aufweist und dazu eingerichtet ist, auf der Vorderseite (310) mit Primärlicht (250) beleuchtet zu werden und Sekundärlicht (350) mit einer anderen Wellenlänge auf der Vorderseite (310) abzugeben,
wobei der Grundkörper (400) einen Indikator (450) zur Positionierung/Orientierung des auf dem Grundkörper (400) aufgebrachten Lichtkonversionselements (300) auf dem Grundkörper (400) aufweist und/oder zumindest einen Indikator (460) zur Positionierung/Orientierung des Grundkörpers (400) zusammen mit dem darauf aufgebrachten Lichtkonversionselement (300) aufweist, und
eine Lichtabgabeeinheit (200), welche dazu eingerichtet ist, das Primärlicht (250) zur Beleuchtung der Vorderseite (310) des Lichtkonversionselements (300) abzugeben und/oder
eine dem Lichtkonversionselement (300) nachgeordnete Optik zur Erfassung, insbesondere Formung, des Sekundärlichts (350),
wobei bevorzugt vorgesehen ist, dass der Indikator (450) zur Positionierung/Orientierung des Lichtkonversionselements (300) auf dem Grundkörper (400) und/oder der Indikator (460) zur Positionierung/Orientierung des Grundkörpers (400) zusammen mit dem darauf aufgebrachten Lichtkonversionselement (300) dazu eingerichtet ist, eine Zentrierung des von dem Lichtkonversionselement (300) abgegebenen Sekundärlichts (350) gegenüber der dem Lichtkonversionselement (300) nachgeordneten Optik zu ermöglichen.

6. Beleuchtungseinrichtung nach dem vorstehenden Anspruch,
wobei die Lichtabgabeeinheit (200) eine Lichtquelle, insbesondere eine Laserlichtquelle, umfasst, welche dazu eingerichtet ist, das Primärlicht (250) zur Beleuchtung des Lichtkonversionselements (300) abzugeben, und/oder
wobei die Lichtabgabeeinheit (200) einen Lichtleiter, insbesondere einen Faserlichtleiter, umfasst, welcher dazu eingerichtet ist, das Primärlicht (250) zur Beleuchtung des Lichtkonversionselements (300) abzugeben, und/oder
wobei die Lichtabgabeeinheit (200) eine Linse umfasst, welche dazu eingerichtet ist, das Primärlicht (250) zur Beleuchtung des Lichtkonversionselements (300) abzugeben und/oder
wobei die Lichtabgabeeinheit (200) derart angeordnet ist, dass das Primärlicht seitlich auf das Lichtkonversionselements (300) eingestrahlt wird,
wobei das Primärlicht (250) insbesondere entlang einer optischen Achse eingestrahlt wird, welche zu einer Normalachse des Lichtkonversionselements (300) und/oder zu einer optischen Achse des Sekundärlichts (350) einen Winkel von größer als 30 Grad, vorzugsweise größer als 45 Grad, besonders bevorzugt von größer als 60 Grad aufweist.

7. Beleuchtungseinrichtung nach einem der zwei vorstehenden Ansprüche,
wobei die Lichtabgabeeinheit (200) dazu eingerichtet und/oder derart angeordnet ist, dass die Primärlichtempfangsfläche (330), innerhalb derer das Lichtkonversionselement (300) mit dem Primärlicht (250) beleuchtet wird, kleiner ist als 1 Quadratmillimeter, vorzugsweise kleiner ist als 0,5 Quadratmillimeter, besonders bevorzugt kleiner ist als 0,2 Quadratmillimeter, und/oder
wobei die Lichtabgabeeinheit (200) eine Strahlungsleistung von mindestens 0,5W aufweist.

8. Grundkörper (400) für eine Lichtkonversionseinrichtung (50) und/oder eine Beleuchtungseinrichtung, insbesondere nach einem der vorstehenden Ansprüche, wobei der Grundkörper (400) insbesondere als Kühlkörper ausgebildet ist,
wobei der Grundkörper (400) eine Vorderseite (410) aufweist, welche dazu ausgebildet ist ein Lichtkonversionselement (300) auf dem Grundkörper (400) aufzubringen,
wobei der Grundkörper (400) einen Indikator (450) zur Positionierung/Orientierung eines Lichtkonversionselements (300) auf dem Grundkörper (400) aufweist, und/oder
wobei der Grundkörper (400) zumindest einen Indikator (460) zur Positionierung/Orientierung des Grundkörpers (400) gegenüber einem Bauteil zum Halten des Grundkörpers (400) aufweist.

9. Grundkörper (400) nach dem vorstehenden Anspruch,
wobei der Indikator (450) zur Positionierung/Orientierung des Lichtkonversionselements (300) auf dem Grundkörper (400) integral in dem Grundkörper (400) ausgebildet ist, insbesondere mit einer Genauigkeit von kleiner 500 Mikrometern, vorzugsweise kleiner 100 Mikrometern, besonders bevorzugt kleiner 50 Mikrometern, und/oder
wobei der Indikator (460) zur Positionierung/Orientierung des Grundkörpers (400) gegenüber einem Bauteil zum Halten des Grundkörpers (400) integral mit dem Grundkörper (400) ausgebildet ist, insbesondere mit einer Genauigkeit von kleiner 500 Mikrometern, vorzugsweise kleiner 100 Mikrometern, besonders bevorzugt kleiner 50 Mikrometern.

10. Grundkörper (400) nach einem der zwei vorstehenden Ansprüche,
wobei der Indikator (450) zur Positionierung/Orientierung des Lichtkonversionselements (300) als Markierung in dem Grundkörper (400) ausgebildet ist, und/oder wobei der Indikator (450) zur Positionierung/Orientierung des Lichtkonversionselements (300) als Erhebung oder als Vertiefung in dem Grundkörper (400) ausgebildet ist.

11. Grundkörper (400) nach einem der drei vorstehenden Ansprüche,
wobei der zumindest eine Indikator (460) zur Positionierung/Orientierung des Grundkörpers (400) gegenüber einem Bauteil zum Halten des Grundkörpers (400) als Kavität in dem Grundkörper (400) ausgebildet ist, insbesondere als Durchgangskavität quer oder senkrecht zur Vorderseite (410) des Grundkörpers (400) und/oder
wobei eine Kavität, insbesondere eine Durchgangskavität, quer oder senkrecht zur Vorderseite (410) des Grundkörpers (400) in dem Grundkörper (400) verläuft und seitlich nach außen geöffnet ist, und/oder
wobei eine Kavität, insbesondere eine Durchgangskavität, quer oder senkrecht zur Vorderseite (410) des Grundkörpers (400) in dem Grundkörper (400) verläuft und seitlich allseits geschlossen ist.

12. Verfahren zur Bearbeitung eines Grundkörpers (400), welcher insbesondere als Kühlkörper ausgebildet ist, umfassend
Bereitstellen eines Grundkörpers (400), welcher insbesondere als Kühlkörper ausgebildet ist,
Ausbilden eines Indikators (450) zur Positionierung/Orientierung eines Lichtkonversionselements (300) auf dem Grundkörper (400) und/oder
Ausbilden eines Indikators (460) zur Positionierung/Orientierung des Grundkörpers (400) gegenüber einem Bauteil zum Halten des Grundkörpers (400),
wobei vorzugsweise zumindest einer der folgenden Verfahrensschritte vorgesehen ist:
(a) dass der Indikator (450) zur Positionierung/Orientierung des Lichtkonversionselements (300) mit dem Grundkörper (400) integral ausgebildet wird, insbesondere mit einer Genauigkeit von kleiner 500 Mikrometern, vorzugsweise kleiner 100 Mikrometern, besonders bevorzugt kleiner 50 Mikrometern,
(b) dass der Indikator (460) zur Positionierung/Orientierung des Grundkörpers (400) gegenüber einem Bauteil zum Halten des Grundkörpers (400) integral mit dem Grundkörper (400) ausgebildet wird, insbesondere mit einer Genauigkeit von kleiner 500 Mikrometern, vorzugsweise kleiner 100 Mikrometern, besonders bevorzugt kleiner 50 Mikrometern,
(c) dass der Indikator (450) zur Positionierung/Orientierung des Lichtkonversionselements (300) als Markierung in dem Grundkörper (400) ausgebildet wird, insbesondere mittels Laserbearbeitung,
(d) der Indikator (450) zur Positionierung/Orientierung des Lichtkonversionselements (300) als Erhebung oder als Vertiefung in dem Grundkörper (400) ausgebildet wird, insbesondere mittels eines Prägeverfahrens.

13. Verfahren zur Bearbeitung eines Grundkörpers (400) nach dem vorstehenden Anspruch,
wobei der zumindest eine Indikator (460) zur Positionierung/Orientierung des Grundkörpers (400) gegenüber einem Bauteil zum Halten des Grundkörpers (400) als Kavität in dem Grundkörper (400) ausgebildet wird, insbesondere als Durchgangskavität quer oder senkrecht zur Vorderseite (410) des Grundkörpers (400) in dem Grundkörper (400) ausgebildet wird, insbesondere mittels Bohren und/oder
wobei eine Kavität, insbesondere eine Durchgangskavität, quer oder senkrecht zur Vorderseite (410) des Grundkörpers (400) in den Grundkörper (400) eingebracht wird, insbesondere derart, dass die Kavität seitlich nach außen geöffnet ist, und/oder
wobei eine Kavität, insbesondere eine Durchgangskavität, quer oder senkrecht zur Vorderseite (410) des Grundkörpers (400) in den Grundkörper (400) eingebracht wird, insbesondere derart dass die Kavität seitlich allseits geschlossen ist.

14. Verfahren zur Herstellung einer Lichtkonversionseinrichtung (50) umfassend
Bereitstellen eines Grundkörpers (400), welcher insbesondere als Kühlkörper ausgebildet ist, mit einem Indikator (450) zur Positionierung/Orientierung eines Lichtkonversionselements (300) auf dem Grundkörper (400), insbesondere hergestellt oder herstellbar nach einem der zwei vorstehenden Ansprüche,
Aufbringen eines Lichtkonversionselements (300) auf den Grundkörper (400), insbesondere mittels des Indikators (450) zur Positionierung/Orientierung eines Lichtkonversionselements (300) auf dem Grundkörper (400).

15. Verfahren zur Herstellung einer Beleuchtungseinrichtung umfassend
Bereitstellen einer Lichtkonversionseinrichtung (50) mit einem Grundkörper (400) und einem auf einer Vorderseite (410) des Grundkörpers (400) aufgebrachten Lichtkonversionselement (300), insbesondere hergestellt oder herstellbar nach dem vorstehenden Anspruch,
wobei der Grundkörper (400) zumindest einen Indikator (460) zur Positionierung/Orientierung des Grundkörpers (400) zusammen mit dem darauf aufgebrachten Lichtkonversionselement (300) aufweist,
Zentrieren des von dem Lichtkonversionselement (300) abgegebenen Sekundärlichts (350) gegenüber einer dem Lichtkonversionselement (300) nachgeordneten Optik mittels des Indikators (460) zur Positionierung/Orientierung des Grundkörpers (400) zusammen mit dem darauf aufgebrachten Lichtkonversionselement (300).
